# EUROPEAN PATENT APPLICATION

(11) **EP 4 534 941 A1**
(43) Date of publication of application: **09.04.2025**
(21) Application number: 23811640.4
(22) Date of filing: 11.05.2023
(51) Int. Cl.: F28D 15/02, F28D 15/06

(54) **CIRCULATION DEVICE FOR TWO-PHASE COOLING SYSTEM AND REFRIGERANT CIRCULATION METHOD IN CIRCULATION DEVICE FOR TWO-PHASE COOLING SYSTEM**

(30) Priority: 27.05.2022 JP 2022086867
(71) Applicant: SHIMADZU CORPORATION, Kyoto-shi, Kyoto 604-8511 (JP)
(72) Inventor: MATSUDA, Shotaro, Kyoto-shi, Kyoto 604-8511 (JP); SEKIMOTO, Shunsuke, Kyoto-shi, Kyoto 604-8511 (JP); YAMAMOTO, Masayuki, Kyoto-shi, Kyoto 604-8511 (JP); OTONO, Kazufumi, Kyoto-shi, Kyoto 604-8511 (JP); YANAI, Isao, Kyoto-shi, Kyoto 604-8511 (JP); HORIGUCHI, Yukio, Kyoto-shi, Kyoto 604-8511 (JP); NISHIURA, Yoshiaki, Kyoto-shi, Kyoto 604-8511 (JP)
(74) Representative: Müller-Boré & Partner Patentanwälte PartG mbB
(86) International application number: PCT/JP2023/017737
(87) International publication number: WO 2023/228765

(57) **Abstract**

A circulation device (100) for a two-phase cooling system includes an inlet connection (41), an outlet connection (42), and a bypass line (75) branching at a portion downstream of a pump (10) and upstream of the inlet connection to allow a refrigerant to flow to a condenser (20) without passing through the inlet connection and the outlet connection, and is operable to circulate the refrigerant not through the inlet connection and the outlet connection but through the bypass line when an evaporator (80) is not connected to the inlet connection and the outlet connection.

## Description

### Technical Field

The present invention relates to a circulation device for a two-phase cooling system and a refrigerant circulation method in the circulation device for a two-phase cooling system, and more particularly, it relates to a circulation device for a two-phase cooling system that constitutes the two-phase cooling system in which a refrigerant is circulated by connecting a removable evaporator to the circulation device, and a refrigerant circulation method in the circulation device for a two-phase cooling system.

### Background Art

Conventionally, a two-phase cooling system in which a refrigerant is circulated by connecting a removable evaporator to a connection is known. A circulation device for such a two-phase cooling system is disclosed in Japanese Patent Laid-Open No. 2003-179375, for example.

Japanese Patent Laid-Open No. 2003-179375 discloses a cooling apparatus (two-phase cooling system) including a plurality of cooling modules selectively mountable into an electronics cabinet. Each cooling module includes an evaporative cold plate including an evaporative flow path, a condenser including a condensing flow path, a vapor conduit, and a liquid conduit. A working fluid flows through the cooling module in the order of the evaporative flow path, the vapor conduit, the condensing flow path, and the liquid conduit to form a pumped two-phase cooling cycle. Japanese Patent Laid-Open No. 2003-179375 discloses that it is advantageous to connect a connection between an evaporative cold plate inlet and the liquid conduit, and a connection between an evaporative cold plate outlet and the vapor conduit by removable connection means. That is, Japanese Patent Laid-Open No. 2003-179375 discloses a cooling apparatus in which the evaporative cold plate (evaporator) is attachable to and detachable from a structure including the condenser, the vapor conduit, and the liquid conduit.

### Prior Art

### Patent Document

Patent Document 1: Japanese Patent Laid-Open No. 2003-179375

### Summary of the Invention

### Problems to be Solved by the Invention

In the cooling apparatus disclosed in Japanese Patent Laid-Open No. 2003-179375, the working fluid circulates through the evaporative cold plate, the vapor conduit, the condenser, and the liquid conduit, and thus when the evaporative cold plate is removed from the structure including the condenser, the vapor conduit, and the liquid conduit, the working fluid cannot be circulated. In such a case, the working fluid does not flow into the condenser, and thus when the working fluid is circulated at a temperature much lower than the outside air temperature, the temperature of the working fluid rises due to heat input due to the temperature outside the cooling apparatus. Thus, immediately after the evaporative cold plate is removed and then reattached, the working fluid with an increased temperature circulates, and thus the cooled working fluid cannot be flowed into the evaporative cold plate. Therefore, immediately after the evaporative cold plate is reattached, the evaporative cold plate cannot immediately cool a target to be cooled. Therefore, it is desired to be able to flow a cooled, low-temperature working fluid (refrigerant) into the evaporative cold plate (evaporator) even immediately after the evaporative cold plate (evaporator) is removed and then reconnected, and to be able to immediately cool the target to be cooled by the evaporative cold plate (evaporator).

The present invention is intended to solve at least one of the above problems. The present invention aims to provide a circulation device for a two-phase cooling system and a refrigerant circulation method in a circulation device for a two-phase cooling system in which a cooled, low-temperature refrigerant can be flowed into a removable evaporator even immediately after the evaporator is removed and then reconnected, and a target to be cooled can be immediately cooled by the evaporator.

### Means for Solving the Problems

A circulation device for a two-phase cooling system according to a first aspect of the present invention constitutes the two-phase cooling system in which a refrigerant is circulated by connecting a removable evaporator to the circulation device, and includes a pump to pump the refrigerant, an inlet connection downstream of the pump connected to an inlet of the evaporator for the refrigerant, an outlet connection downstream of the pump connected to an outlet of the evaporator for the refrigerant, a condenser downstream of the outlet connection to cool the refrigerant, and a bypass line branching at a portion downstream of the pump and upstream of the inlet connection to allow the refrigerant to flow to the condenser without passing through the inlet connection and the outlet connection. The circulation device is operable to circulate the refrigerant not through the inlet connection and the outlet connection but through the bypass line when at least the evaporator is not connected to the inlet connection and the outlet connection.

A refrigerant circulation method in a circulation device for a two-phase cooling system, which constitutes the two-phase cooling system in which a refrigerant is circulated by connecting a removable evaporator to the circulation device, according to a second aspect of the present invention includes circulating the refrigerant not through an inlet connection connected to an inlet of the evaporator for the refrigerant, and an outlet connection connected to an outlet of the evaporator for the refrigerant but through a bypass line operable to allow the refrigerant to flow therethrough when at least the evaporator is not connected to the inlet connection and the outlet connection, and cooling the refrigerant that has flowed through the bypass line into a condenser. Advantageous Effect of the Invention

As described above, the circulation device for a two-phase cooling system according to the first aspect of the present invention includes the bypass line branching at the portion downstream of the pump and upstream of the inlet connection to allow the refrigerant to flow to the condenser without passing through the inlet connection and the outlet connection, and is operable to circulate the refrigerant not through the inlet connection and the outlet connection but through the bypass line when at least the evaporator is not connected to the inlet connection and the outlet connection. Accordingly, even when the removable evaporator is not connected to the inlet connection and the outlet connection, the refrigerant can be circulated through the bypass line, and thus the refrigerant can be continuously cooled by the condenser. Therefore, even immediately after the removable evaporator is removed from the inlet connection and the outlet connection and then reconnected, the cooled, low-temperature refrigerant can be flowed into the evaporator, and a target to be cooled can be immediately cooled by the evaporator.

As described above, the refrigerant circulation method in the circulation device for a two-phase cooling system according to the second aspect of the present invention includes circulating the refrigerant not through the inlet connection connected to the inlet of the evaporator for the refrigerant and the outlet connection connected to the outlet of the evaporator for the refrigerant but through the bypass line operable to allow the refrigerant to flow therethrough when at least the evaporator is not connected to the inlet connection and the outlet connection, and cooling the refrigerant that has flowed through the bypass line into the condenser. Accordingly, similarly to the first aspect, even when the removable evaporator is not connected to the inlet connection and the outlet connection, the refrigerant can be circulated through the bypass line, and thus the refrigerant can be continuously cooled by the condenser. Therefore, even immediately after the removable evaporator is removed from the inlet connection and the outlet connection and then reconnected, the cooled, low-temperature refrigerant can be flowed into the evaporator, and a target to be cooled can be immediately cooled by the evaporator.

### Brief Description of the Drawings

FIG. 1 is a schematic view showing the configuration of the circulation device for a two-phase cooling system with an evaporator connected thereto according to a first embodiment.
FIG. 2 is a schematic view showing the configuration of the circulation device for a two-phase cooling system without the evaporator connected thereto according to the first embodiment.
FIG. 3 is a schematic view showing the configuration of a circulation device for a two-phase cooling system according to a first modified example of the first embodiment.
FIG. 4 is a schematic view showing the configuration of a circulation device for a two-phase cooling system according to a second modified example of the first embodiment.
FIG. 5 is a schematic view showing the configuration of a circulation device for a two-phase cooling system in a refrigerant recovery state according to a second embodiment.
FIG. 6 is a block diagram showing the control configuration of the circulation device for a two-phase cooling system according to the second embodiment.
FIG. 7 is a graph for illustrating a set liquid level according to the second embodiment.
FIG. 8 is a flowchart for illustrating a refrigerant recovery process by a controller according to the second embodiment.
FIG. 9 is a graph for illustrating a set change amount according to a third modified example.
FIG. 10 is a block diagram showing the control configuration of a circulation device for a two-phase cooling system according to a fourth modified example.
FIG. 11 is a schematic view showing an example of a notification by a display according to the fourth modified example.
FIG. 12 is a schematic view showing the configuration of a circulation device for a two-phase cooling system according to a fifth modified example.

### Modes for Carrying Out the Invention

Embodiments embodying the present invention are hereinafter described on the basis of the drawings.

### First Embodiment

### Overall Configuration of Circulation Device for Two-Phase Cooling System

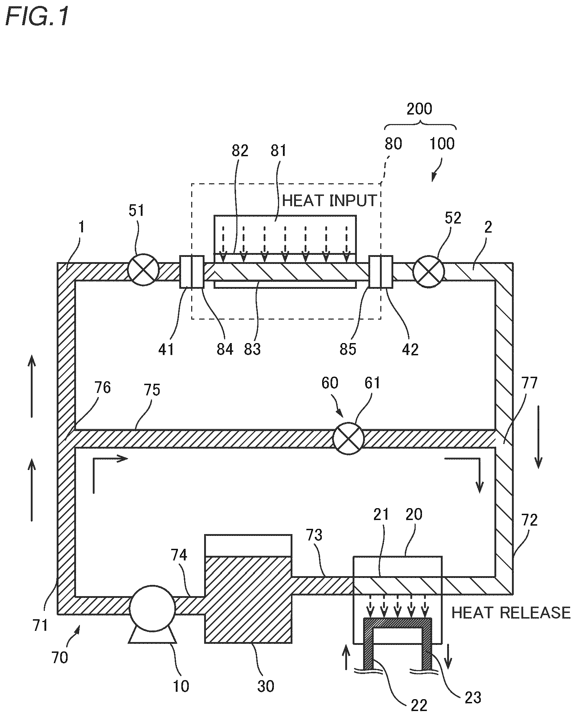

The overall configuration of a circulation device 100 for a two-phase cooling system according to a first embodiment is now described with reference to FIG. 1. FIG. 1 shows the circulation device 100 for a two-phase cooling system with a removable evaporator 80 connected thereto. The circulation device 100 for a two-phase cooling system constitutes a two-phase cooling system 200 in which a refrigerant is circulated by connecting the removable evaporator 80 to the circulation device 100 for a two-phase cooling system. The term "with the removable evaporator 80 connected thereto" refers to a normal operating state in which the evaporator 80 is attached to the circulation device 100 for a two-phase cooling system and cools a heat source 81 (target to be cooled), for example. The circulation device 100 for a two-phase cooling system according to the first embodiment is a portable circulation device. Being removable indicates that the evaporator 80 directly attached to the circulation device 100 for a two-phase cooling system can be removed from the circulation device 100 for a two-phase cooling system, or the same evaporator 80 as the removed evaporator 80 or another evaporator can be directly attached. Two-phase cooling refers to cooling with a gas-liquid mixed fluid, using the heat of vaporization generated when a liquid changes into a gas.

In the drawings, a liquid refrigerant 1 is represented by diagonal lines (hatching) from the upper right to the lower left, and a gas-liquid mixed refrigerant 2 is represented by diagonal lines (hatching) from the upper left to the lower right. Each refrigerant moves in a direction indicated by arrows in the circulation device 100 for a two-phase cooling system.

As shown in FIG. 1, the circulation device 100 for a two-phase cooling system includes a pump 10, a condenser 20, a reservoir 30, an inlet connection 41, an outlet connection 42, an inlet side shut-off valve 51, an outlet side shut-off valve 52, a flow regulator 60, and a refrigerant flow path 70. The refrigerant flow path 70 includes a first refrigerant flow path 71, a second refrigerant flow path 72, a third refrigerant flow path 73, a fourth refrigerant flow path 74, and a bypass line 75. The removable evaporator 80 is connected to the circulation device 100 for a two-phase cooling system. Note that the "inlet side" of the inlet connection 41 refers to the inlet side of the evaporator 80, and the "outlet side" of the outlet connection 42 refers to the outlet side of the evaporator 80. In addition, the "inlet side" of the inlet side shut-off valve 51 refers to the inlet side of the evaporator 80, and the "outlet side" of the outlet side shut-off valve 52 refers to the outlet side of the evaporator 80.

The first refrigerant flow path 71 includes a first end connected to an outlet of the pump 10 and a second end connected to the inlet connection 41. A bifurcation 76 is formed between the first end and the second end of the first refrigerant flow path 71. The second refrigerant flow path 72 includes a first end connected to the outlet connection 42 and a second end connected to an inlet of the condenser 20. A junction 77 is formed between the first end and the second end of the second refrigerant flow path 72. The third refrigerant flow path 73 includes a first end connected to an outlet of the condenser 20 and a second end connected to an inlet of the reservoir 30. The fourth refrigerant flow path 74 includes a first end connected to an outlet of the reservoir 30 and a second end connected to an inlet of the pump 10.

The bypass line 75 branches from the first refrigerant flow path 71 to the second refrigerant flow path at a portion downstream of the pump 10 and upstream of the inlet connection 41 in the first refrigerant flow path 71, and allows the refrigerant to flow to the condenser 20 without passing through the inlet connection 41 and the outlet connection 42. The bypass line 75 branching from the first refrigerant flow path 71 is connected to a portion downstream of the outlet connection 42 and upstream of the condenser 20 in the second refrigerant flow path 72. In the first embodiment, a first end of the bypass line 75 is connected to the bifurcation 76 formed in the first refrigerant flow path 71, and a second end of the bypass line 75 is connected to the junction 77 formed in the second refrigerant flow path 72.

The refrigerant flow path 70 is made of a metal material, such as a stainless steel material, an aluminum material, or a copper material. The refrigerant flow path 70 is formed into a pipe shape.

The pump 10 pumps the liquid phase refrigerant 1. The pump 10 is operated with an output within a predetermined range. The pump 10 pumps the refrigerant to the evaporator 80 via the first refrigerant flow path 71. The pump 10 pumps the refrigerant to the condenser 20 via the first refrigerant flow path 71, the bypass line 75, and the second refrigerant flow path 72. The refrigerant flows into the pump 10 from the reservoir 30 via the fourth refrigerant flow path 74. The pump 10 is provided downstream of the reservoir 30 in the fourth refrigerant flow path 74 and upstream of the evaporator 80 in the first refrigerant flow path 71. The term "upstream of the pump 10" refers to a portion upstream of the pump 10 and does not include the pump 10. In addition, the term "downstream of the pump 10" refers to a portion downstream of the pump 10 and does not include the pump 10. The same applies to the terms "upstream of the condenser 20" and "downstream of the condenser 20", the terms "upstream of the reservoir 30" and "downstream of the reservoir 30", and the term "upstream of the evaporator 80" and "downstream of the evaporator 80.

The pump 10 takes in the liquid phase refrigerant 1 from the inlet of the pump 10 and discharges the liquid phase refrigerant 1 from the outlet of the pump 10. The pump 10 is a centrifugal pump. However, the pump 10 is not limited to a centrifugal pump. The pump 10 may be a mixed flow pump, an axial flow pump, or another known pump. The pump 10 may also be a positive displacement pump.

When the evaporator 80 is connected to the circulation device 100 for a two-phase cooling system, the condenser 20 condenses a gas-phase refrigerant in the gas-liquid mixed refrigerant 2 flowing out of the evaporator 80 to generate the liquid refrigerant 1. In the first embodiment, the condenser 20 cools and condenses the refrigerant by exchanging heat with a coolant 23 flowing in from the outside. The condenser 20 condenses the refrigerant by causing the coolant 23 flowing through the condenser 20 from an external chiller (not shown) to absorb the heat of the refrigerant, for example. The condenser 20 includes a flow path 21 through which the refrigerant flows, and a coolant flow path 22 through which the coolant 23 flows. The condenser 20 allows the gas-liquid mixed refrigerant 2 to flow thereinto from the inlet of the condenser 20 and allows the liquid refrigerant 1 to flow out from the outlet of the condenser 20.

The condenser 20 is provided downstream of the outlet connection 42 in the second refrigerant flow path 72. The refrigerant flows into the condenser 20 via the second refrigerant flow path 72. The refrigerant condensed by the condenser 20 flows into the reservoir 30 via the third refrigerant flow path 73. A coolant having a lower temperature than the liquid refrigerant 1 is used as the coolant 23. In the first embodiment, carbon dioxide is used as the refrigerant, and a liquid containing a hydrofluoroether as a main component is used as the coolant 23. The type of the coolant 23 is selected according to the type of refrigerant. The coolant 23 is not particularly limited as long as the same is a known coolant.

The reservoir 30 stores the liquid refrigerant 1. When there is a gas-liquid mixed refrigerant 2 that has not been completely condensed in the condenser 20, the reservoir 30 separates bubbles (gas-phase refrigerant) contained in the gas-liquid mixed refrigerant 2 and stores the separated bubbles in an upper portion of the reservoir 30. The reservoir 30 is provided downstream of the condenser 20 in the third refrigerant flow path 73. The reservoir 30 allows the liquid refrigerant 1 to flow thereinto from the inlet of the reservoir 30 and allows the liquid refrigerant 1 to flow out from the outlet of the reservoir 30. The reservoir 30 sends the liquid refrigerant 1 to the pump 10 via the fourth refrigerant flow path 74.

The inlet connection 41 connects the first refrigerant flow path 71 to a refrigerant inlet of the evaporator 80. The inlet connection 41 connects the second end of the first refrigerant flow path 71 to the refrigerant inlet provided in the evaporator 80. The inlet connection 41 is a coupling member that is detachable from an inlet side coupling member 84 formed at the refrigerant inlet of the evaporator 80, for example. As the inlet connection 41, a known coupling such as a threaded coupling, a flange coupling, a quick coupling, or a bite coupling is used. The inlet connection 41 is provided downstream of the pump 10.

The outlet connection 42 connects a refrigerant outlet of the evaporator 80 to the second refrigerant flow path 72. The outlet connection 42 connects the refrigerant outlet provided in the evaporator 80 to the first end of the second refrigerant flow path 72. The outlet connection 42 is a coupling member that is detachable from an outlet side coupling member 85 formed at the refrigerant outlet of the evaporator 80, for example. As the outlet connection 42, a known coupling such as a threaded coupling, a flange coupling, a quick coupling, or a bite coupling is used. The outlet connection 42 is provided downstream of the pump 10 and the evaporator 80 and upstream of the condenser 20.

The inlet side shut-off valve 51 is provided between the bifurcation 76 provided in the first refrigerant flow path 71 and the inlet connection 41. That is, the inlet side shut-off valve 51 is provided in the first refrigerant flow path between a bifurcation at which the bypass line 75 branches from the first refrigerant flow path 71 on the downstream side of the pump 10 and the inlet connection 41. The inlet side shut-off valve 51 is configured to open and close the flow path. The inlet side shut-off valve 51 is an on-off valve that can switch the flow path between a fully open state and a fully closed state, for example. The inlet side shut-off valve 51 may be provided integrally with the inlet connection 41. The inlet side shut-off valve 51 may also be provided in the bifurcation 76.

The outlet side shut-off valve 52 is provided between the outlet connection 42 and the junction 77 provided in the second refrigerant flow path 72. That is, the outlet side shut-off valve 52 is provided in the second refrigerant flow path between the outlet connection 42 and a connection portion to which the bypass line 75 is connected on the downstream side of the outlet connection 42. The outlet side shut-off valve 52 is configured to be able to open and close the flow path. The outlet side shut-off valve 52 is an on-off valve that can switch the flow path between a fully open state and a fully closed state, for example. The outlet side shut-off valve 52 may be provided integrally with the outlet connection 42. The outlet side shut-off valve 52 may also be provided in the junction 77.

The flow regulator 60 is provided in the bypass line 75. The flow regulator 60 increases the pressure loss of the bypass line 75 by reducing a portion of the flow path cross-sectional area of the bypass line 75. In the first embodiment, the flow regulator 60 includes an orifice 61. The hole diameter of the orifice 61 is set in advance to adjust the distributions of the flow rate of the refrigerant flowing into the evaporator 80 and the flow rate of the refrigerant flowing into the bypass line 75 in a state in which the evaporator 80 is connected to the circulation device 100 for a two-phase cooling system. In the first embodiment, the hole diameter of the orifice 61 is set such that the flow rate of the refrigerant flowing into the evaporator 80 is greater than the flow rate of the refrigerant flowing into the bypass line 75.

As shown in FIG. 1, in the circulation device 100 for a two-phase cooling system, the evaporator 80 is connected to the inlet ide connection 41 and the outlet connection 42. The evaporator 80 cools the heat source 81, using the heat of vaporization generated when a portion of the liquid refrigerant 1 delivered through the inlet connection 41 is evaporated and changes into the gas-liquid mixed refrigerant **2.** The evaporator 80 includes a cold plate 82 and a refrigerant flow path 83 provided inside the cold plate 82. The inlet connection 41 is connected to a refrigerant inlet of the refrigerant flow path 83, and the outlet connection 42 is connected to a refrigerant outlet of the refrigerant flow path 83. The heat source 81 is provided on one surface of the cold plate 82. The evaporator 80 and the heat source 81 are integrally formed. Note that the refrigerant flow path 83 shown in FIG. 1 is a schematic view. The refrigerant flow path 83 may have a structure that is bent a plurality of times inside the evaporator 80 in order to perform efficient heat exchange. Furthermore, the refrigerant flow path 83 may be formed so as to split into a plurality of paths at the inlet, pass through the inside of the evaporator 80, and merge into one path at the outlet. The structure of the evaporator 80 is not particularly limited.

In the first embodiment, the refrigerant is carbon dioxide. However, the type of the refrigerant is not limited to this. The refrigerant may be chlorofluorocarbon or ammonia, for example.

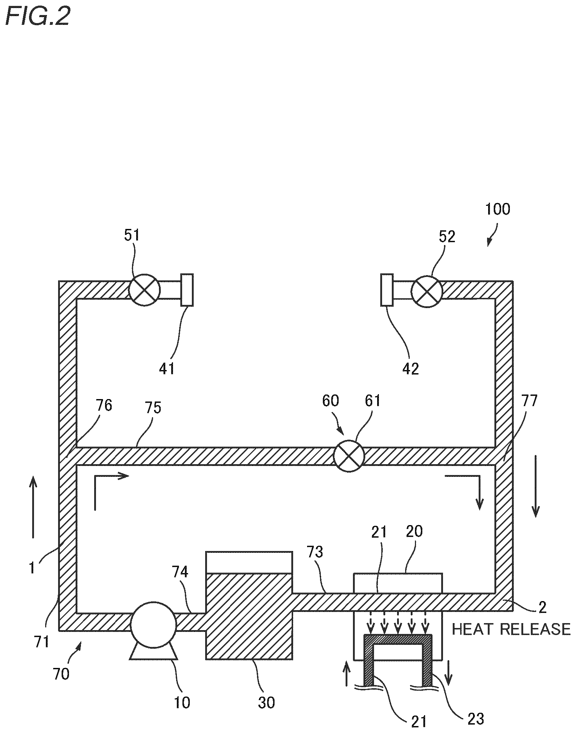

FIG. 2 shows the circulation device 100 for a two-phase cooling system without the removable evaporator 80 connected thereto. The term "without the removable evaporator 80 connected thereto" refers to a state in which the evaporator 80 is removed from the circulation device 100 for a two-phase cooling system due to maintenance of the heat source 81 or the evaporator 80, for example. In the circulation device 100 for a two-phase cooling system without the evaporator 80 connected thereto, the inlet side shut-off valve 51 and the outlet side shut-off valve 52 are in a closed state.

The condenser 20 cools the liquid refrigerant 1 sent from the pump 10 via the bypass line 75 when the evaporator 80 is not connected to the circulation device 100 for a two-phase cooling system. When the evaporator 80 is not connected to the circulation device 100 for a two-phase cooling system, the condenser 20 allows the liquid refrigerant 1 to flow thereinto from the inlet of the condenser 20 and allows the cooled liquid refrigerant 1 to flow out from the outlet of the condenser 20. Note that the remaining configurations of the circulation device 100 for a two-phase cooling system without the evaporator 80 connected thereto are similar to the configurations of the circulation device 100 for a two-phase cooling system with the evaporator 80 connected thereto, as described with reference to FIG. 1, and thus description thereof is omitted.

### Refrigerant Circulation

Refrigerant circulation in the circulation device 100 for a two-phase cooling system with the evaporator 80 connected to the inlet connection 41 and the outlet connection 42 is now described with reference to FIG. **1****.**

The liquid refrigerant 1 is pumped from the pump 10. The refrigerant flows through the first refrigerant flow path 71. At the bifurcation 76 of the first refrigerant flow path 71, a portion of the refrigerant flows through the fully open inlet side shut-off valve 51 and the inlet connection 41, and flows into the evaporator 80. The remaining portion of the refrigerant flows into the bypass line 75, as described below. A portion of the liquid refrigerant 1 that has flowed into the evaporator 80 is evaporated and changes into the gas-liquid mixed refrigerant 2. The gas-liquid mixed refrigerant 2 flows from the evaporator 80 through an outlet connection 42 into the second refrigerant flow path 72. The gas-liquid mixed refrigerant 2 that has flowed into the second refrigerant flow path 72 flows through the fully open outlet side shut-off valve 52 and the junction 77. At the junction 77, the gas-liquid mixed refrigerant 2 merges with the liquid refrigerant 1 that has flowed in from the bypass line 75. The merged gas-liquid mixed refrigerant 2 and the liquid refrigerant 1 that has flowed in from the bypass line 75 flow into the condenser 20 in a gas-liquid mixed state. The gas-phase refrigerant of the gas-liquid mixed refrigerant 2 that has flowed into the condenser 20 is condensed and changes into the liquid refrigerant 1. The condensed liquid refrigerant 1 flows from the condenser 20 through the third refrigerant flow path 73 and flows into the reservoir 30. The refrigerant that has flowed into the reservoir 30 flows through the fourth refrigerant flow path 74 into the pump 10.

At the bifurcation 76 of the first refrigerant flow path 71, the remaining portion of the liquid refrigerant 1 flows into the bypass line 75. The refrigerant that has flowed into the bypass line 75 flows through the orifice 61 provided in the bypass line 75, and flows into the junction 77 of the second refrigerant flow path 72. At the junction 77, the liquid refrigerant 1 that has flowed in from the bypass line 75 merges with the gas-liquid mixed refrigerant 2.

Next, refrigerant circulation in the circulation device 100 for a two-phase cooling system without the evaporator 80 connected to the inlet connection 41 and the outlet connection 42 is described with reference to FIG. 2.

When the evaporator 80 is not connected to the circulation device 100 for a two-phase cooling system, the inlet side shut-off valve 51 and the outlet side shut-off valve 52 are fully closed to prevent the liquid refrigerant 1 from flowing out from the inlet connection 41 and the gas-liquid mixed refrigerant 2 from flowing out from the outlet connection 42. Thus, unlike a state in which the evaporator 80 is connected to the inlet connection 41 and the outlet connection 42, at the bifurcation 76 of the first refrigerant flow path 71, the liquid refrigerant 1 flows into the bypass line 75 except for the refrigerant that flows between the bifurcation 76 and the inlet side shut-off valve 51. At the junction 77 of the second refrigerant flow path 72, the liquid refrigerant 1 that flows in from the bypass line 75 flows through the second refrigerant flow path 72 and flows into the condenser 20.

The liquid refrigerant 1 is pumped from the pump 10. The liquid refrigerant 1 flows through the first refrigerant flow path 71. At the bifurcation 76 of the first refrigerant flow path 71, the liquid refrigerant 1 flows into the bypass line 75. The liquid refrigerant 1 that has flowed into the bypass line 75 flows through the orifice 61 provided in the bypass line 75 and flows into the junction 77 of the second refrigerant flow path 72. The liquid refrigerant 1 that has flowed into the junction 77 flows through the second refrigerant flow path 72 and flows into the condenser 20, except for the refrigerant that flows between the junction 77 and the outlet side shut-off valve 52. The liquid refrigerant 1 that has flowed into the condenser 20 is cooled or maintained in a cooled state. The liquid refrigerant 1 flows from the condenser 20 through the third refrigerant flow path 73 into the reservoir 30. The refrigerant that has flowed into the reservoir 30 flows through the fourth refrigerant flow path 74 into the pump 10.

### Advantages of First Embodiment

In the first embodiment, the following advantages are obtained.

In the first embodiment, as described above, the circulation device 100 for a two-phase cooling system includes the bypass line 75 branching at the portion downstream of the pump 10 and upstream of the inlet connection 41 to allow the refrigerant to flow to the condenser 20 without passing through the inlet connection 41 and the outlet connection 42, and is operable to circulate the refrigerant not through the inlet connection 41 and the outlet connection 42 but through the bypass line 75 when at least the evaporator 80 is not connected to the inlet connection 41 and the outlet connection 42. Accordingly, even when the removable evaporator 80 is not connected to the inlet connection 41 and the outlet connection 42, the liquid refrigerant 1 can be circulated through the bypass line 75, and thus the liquid refrigerant 1 can be continuously cooled by the condenser 20. Therefore, even immediately after the removable evaporator 80 is removed from the inlet connection 41 and the outlet connection 42 and then reconnected, the cooled, low-temperature liquid refrigerant 1 can be flowed into the evaporator 80, and the heat source 81 can be immediately cooled by the evaporator 80.

In the first embodiment, as described above, the refrigerant circulation method includes a step of circulating the refrigerant not through the inlet connection 41 and the outlet connection 42 but through the bypass line 75 operable to allow the refrigerant to flow therethrough when at least the evaporator 80 is not connected to the inlet connection 41 and the outlet connection 42, and a step of cooling the refrigerant that has flowed through the bypass line 75 into the condenser 20. Accordingly, even when the removable evaporator 80 is not connected to the inlet connection 41 and the outlet connection 42, the liquid refrigerant 1 can be circulated through the bypass line 75, and thus the liquid refrigerant 1 can be continuously cooled by the condenser 20. Therefore, even immediately after the removable evaporator 80 is removed from the inlet connection 41 and the outlet connection 42 and then reconnected, the cooled, low-temperature liquid refrigerant 1 can be flowed into the evaporator 80, and the heat source 81 can be immediately cooled by the evaporator 80.

In the first embodiment, the circulation device 100 for a two-phase cooling system is configured as follows such that the following advantages are further obtained.

That is, in the first embodiment, as described above, in the normal operating state in which the evaporator 80 is connected to the inlet connection 41 and the outlet connection 42, a portion of the refrigerant is circulated through the evaporator 80, and the remaining portion of the refrigerant is circulated through the bypass line 75. Accordingly, even when it becomes impossible to circulate the refrigerant through the evaporator 80 due to blockage in the evaporator 80, the liquid phase refrigerant 1 can be circulated through the bypass line 75 in the normal operating state in which the evaporator 80 is connected to the inlet connection 41 and the outlet connection 42, the liquid refrigerant 1 can be circulated through the bypass line 75. Therefore, it is possible to reduce or prevent the occurrence of malfunctions in the circulation device 100 for a two-phase cooling system caused by an increase in pressure at the outlet of the pump 10 due to an inability to circulate the refrigerant.

In the first embodiment, as described above, the circulation device 100 for a two-phase cooling system further includes the flow regulator 60 in the bypass line 75. The flow regulator 60 can reduce a portion of the flow path cross-sectional area of the bypass line 75, and thus the pressure loss of the bypass line 75 can be increased. Thus, it is possible to reduce the flow rate of the refrigerant flowing into the bypass line 75 when the evaporator 80 is connected to the circulation device 100 for a two-phase cooling system. Therefore, when the evaporator 80 is connected to the circulation device 100 for a two-phase cooling system, the flow rate of the refrigerant flowing into the evaporator 80 and the flow rate of the refrigerant flowing into the bypass line 75 can be adjusted such that the flow rate of the refrigerant flowing into the evaporator 80 is greater than the flow rate of the refrigerant flowing into the bypass line 75.

In the first embodiment, as described above, the flow regulator 60 includes the orifice 61 to adjust the flow rate of the refrigerant flowing through the bypass line 75. The orifice 61 can increase the pressure loss of the bypass line 75, and thus the flow rate of the refrigerant flowing into the bypass line 75 can be reduced. Therefore, the flow rate of the liquid refrigerant 1 flowing into the evaporator 80 at the bifurcation 76 and the flow rate of the liquid refrigerant 1 flowing into the bypass line 75 can be adjusted with a simple configuration such that the flow rate of the refrigerant flowing into the evaporator 80 is greater than the flow rate of the refrigerant flowing into the bypass line 75.

In the first embodiment, as described above, the condenser 20 is operable to condense and cool the gas-phase refrigerant contained in the gas-liquid mixed refrigerant 2 of the refrigerant with the coolant 23 flowing in from the outside, or to cool the liquid refrigerant 1 of the refrigerant. The gas-phase refrigerant contained in the gas-liquid mixed refrigerant 2 and the liquid refrigerant 1 are cooled by the coolant 23 flowing in from the outside, and thus it is possible to simplify the configuration of the condenser 20 while reliably cooling the refrigerant.

In the first embodiment, as described above, the bypass line 75 branches at the portion downstream of the pump 10 and upstream of the inlet connection 41, and is connected to the portion downstream of the outlet connection 42 and upstream of the condenser 20. Accordingly, the bypass line 75 is not directly connected to the condenser 20, but is connected to the flow path between the outlet connection 42 and the condenser 20. Therefore, a plurality of refrigerant flow paths are not connected to the condenser 20, and thus the configuration of the condenser 20 can be further simplified. Consequently, an increase in the size of the circulation device 100 for a two-phase cooling system can be further reduced or prevented.

In the first embodiment, as described above, the circulation device 100 for a two-phase cooling system further includes the inlet side shut-off valve 51 between the bifurcation at which the bypass line 75 branches on the downstream side of the pump 10 and the inlet connection 41 to open and close the refrigerant flow path, and the outlet side shut-off valve 52 between the outlet connection 42 and the connection portion to which the bypass line 75 is connected on the downstream side of the outlet connection 42 to open and close the refrigerant flow path. Accordingly, when the evaporator 80 is not connected to the circulation device 100 for a two-phase cooling system, the inlet side shut-off valve 51 and the outlet side shut-off valve 52 are fully closed such that the liquid refrigerant 1 can be prevented from flowing out from the inlet connection 41, and the gas-liquid mixed refrigerant 2 can be prevented from flowing out from the outlet connection 42. Furthermore, when the evaporator 80 is removed from the inlet connection 41 and the outlet connection 42, the inlet side shut-off valve 51 and the outlet side shut-off valve 52 are fully closed before the evaporator 80 is removed. Thus, the liquid refrigerant 1 circulating through the bypass line 75 can be cooled by the condenser 20 without stopping the condenser 20. Therefore, even immediately after the removable evaporator 80 is connected to the inlet connection 41 and the outlet connection 42, the appropriately cooled refrigerant can be flowed into the evaporator 80, and the evaporator 80 can cool the heat source 81 more immediately.

In the first embodiment, as described above, the circulation device 100 for a two-phase cooling system further includes the reservoir 30 downstream of the condenser 20 and upstream of the pump 10. Accordingly, when there is a gas-liquid mixed refrigerant 2 that has not been completely condensed in the condenser 20, the reservoir 30 can separate the bubbles (gas-phase refrigerant) contained in the gas-liquid mixed refrigerant 2 to send only the liquid refrigerant 1 to the pump 10. Therefore, the occurrence of malfunctions of the pump 10 caused by the bubbles (gas-phase refrigerant) contained in the refrigerant can be reduced or prevented.

In the first embodiment, as described above, when the evaporator 80 is connected to the inlet connection 41 and the outlet connection 42, the gas-liquid mixed refrigerant 2 flowing out of the evaporator 80 flows into the condenser 20. Accordingly, the gas-liquid mixed refrigerant 2 is flowed out of the evaporator 80 without completely evaporating the liquid refrigerant 1 in the evaporator 80, and thus the possibility can be reduced or prevented that cooling of the heat source using the latent heat of evaporation in the evaporator 80 becomes insufficient.

### Second Embodiment

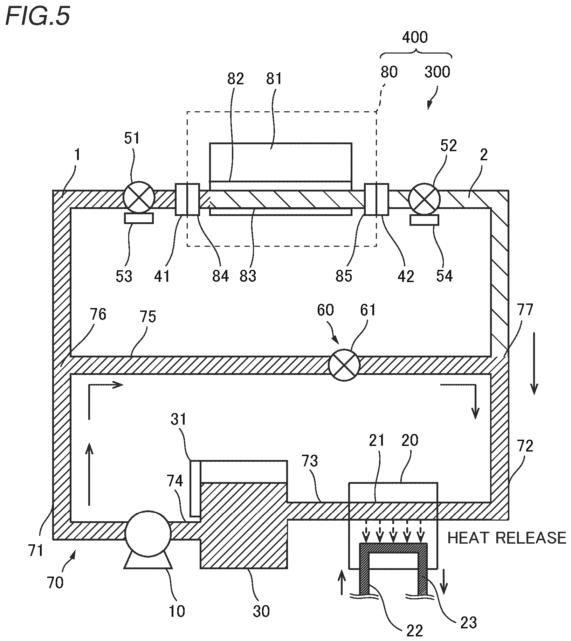

The overall configuration of a circulation device 300 for a two-phase cooling system according to a second embodiment and a refrigerant recovery method for recovering a refrigerant from an evaporator 80 are now described with reference to FIGS. 5 to 8.

For example, when maintenance is performed on an evaporator attached to the circulation device for a two-phase cooling system, the evaporator attached to the circulation device for a two-phase cooling system is removed from the circulation device for a two-phase cooling system. When the evaporator is removed from the circulation device for a two-phase cooling system, the remaining liquid refrigerant may vaporize and flow out when the liquid refrigerant remains in a refrigerant flow path inside the evaporator, resulting in a loss of refrigerant or freezing due to the heat of vaporization. Therefore, in order to reduce the amount of refrigerant remaining inside the evaporator when the evaporator is removed from the circulation device for a two-phase cooling system, it is necessary to recover the refrigerant remaining in the refrigerant flow path inside the evaporator into a reservoir before the evaporator is removed from the circulation device for a two-phase cooling system.

### Overall Configuration of Circulation Device for Two-Phase Cooling System

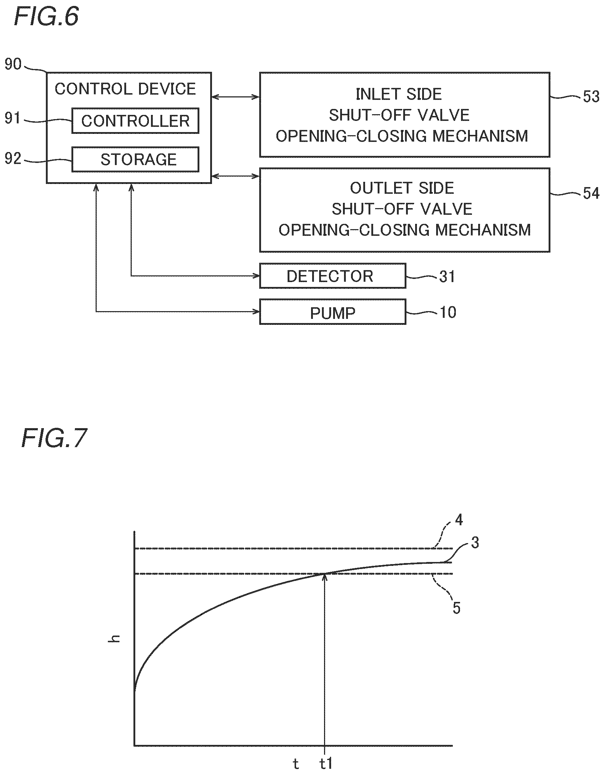

The overall configuration of the circulation device 300 for a two-phase cooling system according to the second embodiment is now described with reference to FIGS. 5 and 6. FIG. 5 shows the circulation device 300 for a two-phase cooling system in a refrigerant recovery state in which a refrigerant is recovered from the evaporator 80. In the circulation device 300 for a two-phase cooling system, in the refrigerant recovery state, the evaporator 80 is connected to an inlet connection 41 and an outlet connection 42, an inlet side shut-off valve 51 is closed, and an outlet side shut-off valve 52 is open. The same or similar configurations as those of the first embodiment are denoted by the same reference numerals, and description thereof is omitted.

The circulation device 300 for a two-phase cooling system according to the second embodiment further includes an inlet side shut-off valve opening-closing mechanism 53, an outlet side shut-off valve opening-closing mechanism 54, a detector 31, and a control device 90 (see FIG. 6), as compared with the circulation device 300 for a two-phase cooling system according to the first embodiment.

The inlet side shut-off valve opening-closing mechanism 53 is configured to switch the inlet side shut-off valve 51 between an open state and a closed state. The inlet side shut-off valve opening-closing mechanism 53 includes a motor etc., for example. The inlet side shut-off valve opening-closing mechanism 53 is connected to a controller 91 (see FIG. 6). The inlet side shut-off valve 51 is opened and closed by the inlet side shut-off valve opening-closing mechanism 53 under the control of the controller 91.

The outlet side shut-off valve opening-closing mechanism 54 is configured to switch the outlet side shut-off valve 52 between an open state and a closed state. The outlet side shut-off valve opening-closing mechanism 54 includes a motor etc., for example. The outlet side shut-off valve opening-closing mechanism 54 is connected to the controller 91 (see FIG. 6). The outlet side shut-off valve 52 is opened and closed by the outlet side shut-off valve opening-closing mechanism 54 under the control of the controller 91. The configurations of the inlet side shut-off valve opening-closing mechanism 53 and the outlet side shut-off valve opening-closing mechanism 54 are not particularly limited as long as the same are known valve opening-closing mechanisms.

The detector 31 detects the amount of recovered refrigerant. Specifically, the detector 31 detects the amount of refrigerant stored in a reservoir 30 as the amount of recovered refrigerant. The detector 31 is a liquid level sensor, for example, and measures the liquid level 3 (see FIG. 7) of a liquid refrigerant stored in the reservoir 30.

As shown in FIG. 6, the control device 90 includes the controller 91 and a storage 92. The controller 91 performs a control to stop the operation of the pump 10 to terminate a refrigerant recovery process based on the detection result of the detector 31. Furthermore, the controller 91 performs a control to prevent the refrigerant from flowing out from the outlet side shut-off valve 52 toward the outlet connection 42 by controlling the outlet side shut-off valve opening-closing mechanism 54 to close the outlet side shut-off valve 52 based on the detection result of the detector 31. The controller 91 includes a processor such as a central processing unit (CPU). The storage 92 includes a volatile storage device and a non-volatile storage device. The storage 92 stores the set storage amount of the refrigerant in the reservoir 30 described below, a program for setting the set storage amount, etc. The set storage amount includes a set liquid level 5 (see FIG. 7) described below. The program for setting the set storage amount includes a program for setting the set liquid level 5. The volatile storage device is used for temporary storage when the controller 91 performs calculations.

### Refrigerant Circulation when Refrigerant is Recovered from Evaporator

Refrigerant circulation when the refrigerant is recovered from the evaporator 80 connected to the circulation device 300 for a two-phase cooling system is now described with reference to FIG. 5.

In the circulation device 300 for a two-phase cooling system in the refrigerant recovery state, the evaporator 80 is connected to the inlet connection 41 and the outlet connection 42. The inlet side shut-off valve 51 is in a closed state, and the outlet side shut-off valve 52 is in an open state. A heat source 81 is not generating heat.

A liquid refrigerant 1 is pumped from a pump 10. The liquid refrigerant 1 flows through a first refrigerant flow path 71. The inlet side shut-off valve 51 is in a fully closed state, and thus the liquid refrigerant 1 flows into a bypass line 75 at a bifurcation 76 of the first refrigerant flow path 71, except for the refrigerant that flows between the bifurcation 76 and the inlet side shut-off valve 51. The liquid refrigerant 1 that has flowed into the bypass line 75 flows into a junction 77 of a second refrigerant flow path 72. The liquid refrigerant 1 that has flowed into the junction 77 flows through the second refrigerant flow path 72 into a condenser 20. The refrigerant that has flowed into the condenser 20 flows through a third refrigerant flow path 73 into the reservoir 30. The refrigerant that has flowed into the reservoir 30 flows through a fourth refrigerant flow path 74 into the pump 10.

The liquid refrigerant 1 is not pumped from the pump 10 to the evaporator 80. Therefore, the liquid refrigerant 1 circulating through the circulation device 300 for a two-phase cooling system does not flow into the evaporator 80 in the refrigerant recovery state. Then, immediately after the inlet side shut-off valve 51 is fully closed, the liquid refrigerant 1 remains in a refrigerant flow path 83 inside the evaporator 80. Although the heat source 81 has stopped generating heat, the temperature inside the evaporator 80 rises due to heat from the outside air. Due to the rise in the temperature inside the evaporator 80, the temperature and pressure of the liquid refrigerant 1 remaining in the evaporator 80 rise, and a portion of the liquid refrigerant 1 is evaporated and changes into a gas-liquid mixed refrigerant 2.

The liquid refrigerant 1 pumped from the pump 10 flows from the bypass line 75 into the junction 77 of the second refrigerant flow path 72, and circulates through the second refrigerant flow path 72, the condenser 20, the third refrigerant flow path 73, the reservoir 30, and the fourth refrigerant flow path 74. The circulating liquid refrigerant 1 is cooled or maintained in a cooled state by the condenser 20. Therefore, the pressure of a gas-phase refrigerant of the gas-liquid mixed refrigerant 2 remaining in the evaporator 80 is higher than the pressure of the liquid refrigerant 1 circulating through the circulation device 300 for a two-phase cooling system. That is, a pressure difference between the pressure of the gas-phase refrigerant contained in the gas-liquid mixed refrigerant 2 in the evaporator 80 and the pressure of the liquid refrigerant 1 circulating in the path from the junction 77 of the second refrigerant flow path 72 through the condenser 20, the reservoir 30, the pump 10, and the bypass line 75 becomes large. Due to this pressure difference, the gas-liquid mixed refrigerant 2 in the evaporator 80 flows out of the evaporator 80 toward the junction 77 of the second refrigerant flow path 72. Specifically, the gas-phase refrigerant of the gas-liquid mixed refrigerant 2 in the evaporator 80 flows out of the evaporator 80 toward the junction 77 of the second refrigerant flow path 72, and flows out so as to push the liquid refrigerant of the gas-liquid mixed refrigerant 2 in the evaporator 80 out of the evaporator 80. Then, at the junction 77, the gas-liquid mixed refrigerant 2 that has flowed out of the evaporator 80 merges with the liquid refrigerant 1 that has flowed in from the bypass line 75, and the gas-phase refrigerant contained in the merged gas-liquid mixed refrigerant 2 is condensed. After the merging, the liquid refrigerant 1 flows through the second refrigerant flow path 72 into the condenser 20. That is, the gas-liquid mixed refrigerant 2 in the evaporator 80 flows through the second refrigerant flow path 72 and is guided to the condenser 20.

Thus, the refrigerant remaining in the refrigerant flow path inside the evaporator 80 is recovered into the reservoir 30. The flow path 83 inside the evaporator 80 cannot be evacuated, and thus all of the refrigerant inside the evaporator 80 cannot be recovered. However, it is possible to reduce the amount of refrigerant remaining inside the evaporator 80 when the evaporator 80 is removed from the circulation device 300 for a two-phase cooling system.

### Control of Termination of Refrigerant Recovery Process by Controller based on Detection Result of Detector

The control of termination of the refrigerant recovery process by the controller 91 based on the detection result of the detector 31 is now described with reference to FIG. 7.

In the refrigerant recovery state, when the amount of stored refrigerant detected by the detector 31 while the refrigerant is circulating through the bypass line 75 without passing through the evaporator 80 becomes equal to or greater than the set storage amount, which is set in advance, the controller 91 performs a control to prevent the refrigerant from flowing out from the outlet side shut-off valve 52 toward the outlet connection 42 by closing the outlet side shut-off valve 52, and to terminate the refrigerant recovery process by stopping the operation of the pump 10. The set storage amount includes the set liquid level 5. The amount of stored refrigerant includes the liquid level 3 of the refrigerant.

As shown in FIG. 2, before the evaporator 80 is connected to the circulation device 300 for a two-phase cooling system, the refrigerant is first circulated through the bypass line 75 without passing through the inlet connection 41 and the outlet connection 42. That is, the refrigerant circulates through the circulation device 300 for a two-phase cooling system in a state in which the evaporator 80 is not connected to the inlet connection 41 and the outlet connection 42. At this time, the detector 31 (see FIG. 5) measures the liquid level of the liquid refrigerant 1 stored in the reservoir 30.

When the liquid level 3 (see FIG. 7) of the liquid refrigerant 1 stored in the reservoir 30 in the refrigerant recovery state becomes equivalent to the liquid level of the liquid refrigerant 1 stored in the reservoir 30 in a state in which the evaporator 80 is not connected, it can be said that the refrigerant remaining in the evaporator 80 has been recovered into the reservoir 30. However, as described above, it is not possible to recover all of the refrigerant in the evaporator 80. Therefore, as shown in FIG. 7, the set liquid level 5 is set based on the liquid level 4 of the liquid refrigerant 1 stored in the reservoir 30 in a state in which the evaporator 80 is not connected. The set liquid level 5 refers to the liquid level of the liquid refrigerant 1 stored in the reservoir 30 in the refrigerant recovery state, which is set by subtracting a margin such as the amount of refrigerant in the evaporator 80 that cannot be recovered described above from the liquid level 4 of the liquid refrigerant 1 stored in the reservoir 30 in a state in which the evaporator 80 is not connected. Therefore, when the liquid level of the liquid refrigerant stored in the reservoir 30 in the refrigerant recovery state becomes equal to or greater than the set liquid level 5, it can be considered that the refrigerant remaining in the evaporator 80 has been recovered into reservoir 30.

The set liquid level 5 is set by the controller 91. That is, the controller 91 acquires the liquid level 4 of the liquid refrigerant 1 stored in the reservoir 30 in a state in which the evaporator 80 is not connected, which is detected by the detector 31, and sets the set liquid level 5 by executing the program for setting the set liquid level 5 stored in the storage 92. The set liquid level 5, which is set, is stored in the storage 92.

For example, when the evaporator 80 is removed from the circulation device 300 for a two-phase cooling system to perform maintenance on the evaporator 80, the refrigerant is recovered from the evaporator 80 before the evaporator 80 is removed. That is, in the refrigerant recovery state in which the evaporator 80 is connected to the inlet connection 41 and the outlet connection 42, the inlet side shut-off valve 51 is in the closed state, and the outlet side shut-off valve 52 is in the open state, as shown in FIG. 5 from a state in which the evaporator 80 is connected to the inlet connection 41 and the outlet connection 42, the inlet side shut-off valve 51 and the outlet side shut-off valve 52 are in the open state, and the heat source 81 is cooled by the evaporator 80, as shown in FIG. 1, the refrigerant is circulated through the bypass line 75 without passing through the evaporator 80. In the refrigerant recovery state, heat generation from the heat source 81 is stopped. At this time, the detector 31 measures the liquid level 3 (see FIG. 7) of the liquid refrigerant 1 stored in the reservoir 30 in the refrigerant recovery state.

The controller 91 acquires the liquid level 3 of the liquid refrigerant 1 stored in the reservoir 30, detected by the detector 31. As shown in FIG. 7, the liquid level h (liquid level 3) of the liquid refrigerant 1 stored in the reservoir 30 rises with the passage of time t. When the liquid level 3 of the liquid refrigerant 1 detected by the detector 31 becomes equal to or greater than the preset set liquid level 5 (time t1), the controller 91 performs a control to close the outlet side shut-off valve 52 to prevent the refrigerant from flowing out from the outlet side shut-off valve 52 toward the outlet connection 42, and also performs a control to stop the operation of the pump 10 to terminate the refrigerant recovery process.

### Refrigerant Recovery Process by Controller

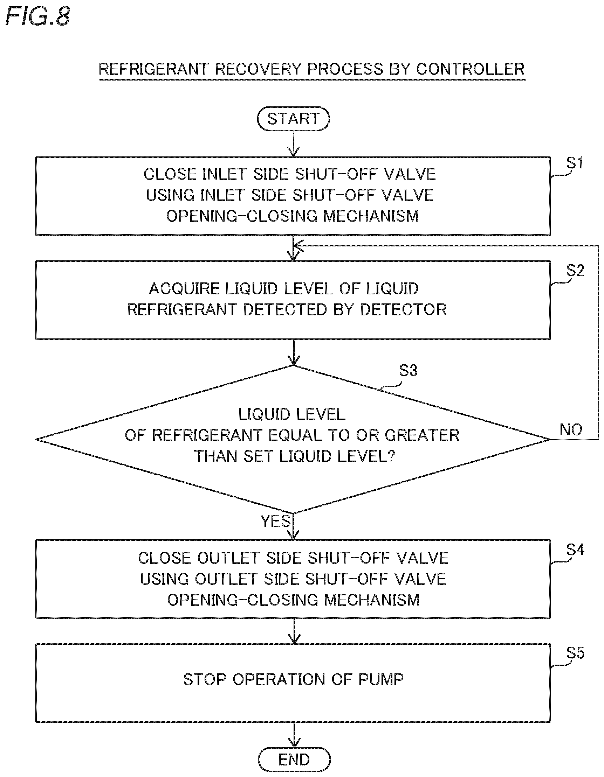

The refrigerant recovery process by the controller 91 according to the second embodiment is now described with reference to FIG. 8. Process steps can be reversed in order or can be executed simultaneously as long as there are no contradictions.

In step S1, when the evaporator 80 is connected, the inlet side shut-off valve 51 and the outlet side shut-off valve 52 are in the open state, and the heat source 81 is being cooled by the evaporator 80, the controller 91 closes the inlet side shut-off valve 51 using the inlet side shut-off valve opening-closing mechanism 53 to enter the refrigerant recovery state after the heat source 81 stops generating heat. In the refrigerant recovery state, the refrigerant is circulated through the bypass line 75 without passing through the evaporator 80. The process then advances to step S2.

In step S2, the controller 91 acquires the liquid level 3 of the liquid refrigerant 1 stored in the reservoir 30, detected by the detector 31. After that, the process advances to step S3.

In step S3, when the acquired liquid level 3 of the liquid refrigerant 1 is equal to or greater than the set liquid level 5 (Yes in step S3), the process advances to step S4, and when the acquired liquid level 3 is less than the set liquid level 5 (No in step S3), the process advances to step S2.

In step S4, the controller 91 closes the outlet side shut-off valve 52 using the outlet side shut-off valve opening-closing mechanism 54. After that, the process advances to step S5.

In step S5, the controller 91 stops the operation of the pump 10. After that, the refrigerant recovery process is terminated.

### Advantages of Second Embodiment

In the second embodiment, the following advantages are obtained.

In the second embodiment, as described above, the circulation device 300 for a two-phase cooling system further includes the inlet side shut-off valve 51 between the bifurcation 76 at which the bypass line 75 branches on the downstream side of the pump 10, and the inlet connection 41 to open and close the refrigerant flow path, and when the refrigerant is recovered from the evaporator 80, the refrigerant is circulated through the bypass line 75 without passing through the evaporator 80, and the refrigerant in the evaporator 80 is led to the condenser 20, in the refrigerant recovery state in which the evaporator 80 is connected to the inlet connection 41 and the outlet connection 42 and the inlet side shut-off valve 51 is closed. The inlet side shut-off valve 51 is closed such that the circulating liquid refrigerant 1 does not flow into the evaporator 80 and heat is input to the evaporator 80 from the outside air, and thus the temperature inside the evaporator 80 rises. Therefore, the temperature and pressure of the liquid refrigerant 1 remaining in the evaporator 80 rise, and a portion of the liquid refrigerant 1 in the evaporator 80 is evaporated and changes into the gas-liquid mixed refrigerant 2. Accordingly, a pressure difference is generated between the pressure of the gas-phase refrigerant contained in the gas-liquid mixed refrigerant 2 in the evaporator 80 and the pressure of the liquid refrigerant 1 circulating in the path from the junction 77 of the second refrigerant flow path 72 through the condenser 20, the reservoir 30, the pump 10, and the bypass line 75, and thus the gas-liquid mixed refrigerant 2 in the evaporator 80 can be caused to flow out of the evaporator 80 toward the junction 77 of the second refrigerant flow path 72. Furthermore, the liquid refrigerant 1 in the evaporator 80 can be changed into the gas-liquid mixed refrigerant 2 due to the rise in the temperature inside the evaporator 80, and thus there is no need to provide additional equipment such as a heater to change the refrigerant into the gas-liquid mixed refrigerant 2. For these reasons, an increase in the number of components and the complexity of the structure can be reduced or prevented, and the refrigerant remaining in the refrigerant flow path 83 inside the evaporator 80 can be easily recovered.

In the second embodiment, as described above, the circulation device 300 for a two-phase cooling system further includes the detector 31 to detect the amount of recovered refrigerant, and the controller 91 configured or programmed to stop the operation of the pump 10 to terminate the refrigerant recovery process based on the detection result of the detector 31. Accordingly, the refrigerant recovery process can be terminated based on the detection result of the detector 31 that detects the amount of recovered refrigerant. Therefore, the refrigerant recovery process can be reliably performed based on the detection result of the detector 31 that detects the amount of recovered refrigerant.

In the second embodiment, as described above, the circulation device 300 for a two-phase cooling system further includes the reservoir 30 downstream of the condenser 20 and upstream of the pump 10, and the detector 31 is operable to detect the amount of refrigerant stored in the reservoir 30 as the amount of recovered refrigerant. Accordingly, based on the detection result of the amount of refrigerant stored in the reservoir 30 as the amount of recovered refrigerant, the operation of the pump 10 can be stopped to terminate the refrigerant recovery process. Therefore, the detection result of the amount of recovered refrigerant can be acquired by the simple configuration of the detector 31, and thus the complexity of the structure of the circulation device 300 for a two-phase cooling system can be reduced or prevented.

In the second embodiment, as described above, the controller 91 is configured or programmed to, in the refrigerant recovery state, perform a control to stop the operation of the pump 10 to terminate the refrigerant recovery process when the amount of stored refrigerant detected by the detector 31 while the refrigerant is circulating through the bypass line 75 without passing through the evaporator 80 becomes equal to or greater than the set storage amount, which is set in advance. Accordingly, based on the set storage amount, it is possible to more easily detect whether the refrigerant remaining in the evaporator 80 has been recovered into the reservoir 30. Therefore, based on the set storage amount, the refrigerant recovery process can be more easily and reliably performed.

In the second embodiment, as described above, the circulation device 300 for a two-phase cooling system further includes the outlet side shut-off valve 52 between the outlet connection 42 and the connection portion to which the bypass line 75 is connected on the downstream side of the outlet connection 42 to open and close the refrigerant flow path, and the controller 91 is configured or programmed to, based on the detection result of the detector 31, perform a control to close the outlet side shut-off valve 52 to prevent the refrigerant from flowing out from the outlet side shut-off valve 52 toward the outlet connection **42.** Accordingly, for example, when the evaporator 80 is removed from the circulation device 300 for a two-phase cooling system, it is possible to prevent the refrigerant from flowing out from the outlet side shut-off valve 52 to the outside, and thus additional refrigerant charging can be reduced or prevented.

In the second embodiment, as described above, the refrigerant circulation method includes circulating the refrigerant not through the evaporator 80 but through the bypass line 75 and leading the refrigerant in the evaporator 80 to the condenser 20, in the refrigerant recovery state in which the evaporator 80 is connected to the inlet connection 41 and the outlet connection 42 and the inlet side shut-off valve 51 between the bifurcation 76 at which the bypass line 75 branches and the inlet connection 41 is closed, when the refrigerant is recovered from the evaporator 80, and stopping the refrigerant circulation to terminate the refrigerant recovery process based on the detection result of the amount of recovered refrigerant. The inlet side shut-off valve 51 is closed such that the circulating liquid refrigerant 1 does not flow into the evaporator 80 and heat is input to the evaporator 80 from the outside air, and thus the temperature inside the evaporator 80 rises. Therefore, the temperature and pressure of the liquid refrigerant 1 remaining in the evaporator 80 rise, and a portion of the liquid refrigerant 1 is evaporated and changes into the gas-liquid mixed refrigerant 2. Accordingly, a pressure difference is generated between the pressure of the gas-phase refrigerant contained in the gas-liquid mixed refrigerant 2 in the evaporator 80 and the pressure of the liquid refrigerant 1 circulating in the path from the junction 77 of the second refrigerant flow path 72 through the condenser 20, the reservoir 30, the pump 10, and the bypass line 75, and thus the gas-liquid mixed refrigerant 2 in the evaporator 80 can be caused to flow out of the evaporator 80 toward the junction 77 of the second refrigerant flow path 72. Furthermore, the liquid refrigerant 1 in the evaporator 80 can be changed into the gas-liquid mixed refrigerant 2 due to the rise in the temperature inside the evaporator 80, and thus there is no need to provide additional equipment such as a heater to change the refrigerant into the gas-liquid mixed refrigerant 2. For these reasons, an increase in the number of components and the complexity of the structure can be reduced or prevented, and the refrigerant remaining in the refrigerant flow path 83 inside the evaporator 80 can be easily recovered.

### Modified Examples

The embodiments disclosed this time must be considered as illustrative in all points and not restrictive. The scope of the present invention is not shown by the above description of the embodiments but by the scope of claims for patent, and all modifications (modified examples) within the meaning and scope equivalent to the scope of claims for patent are further included.

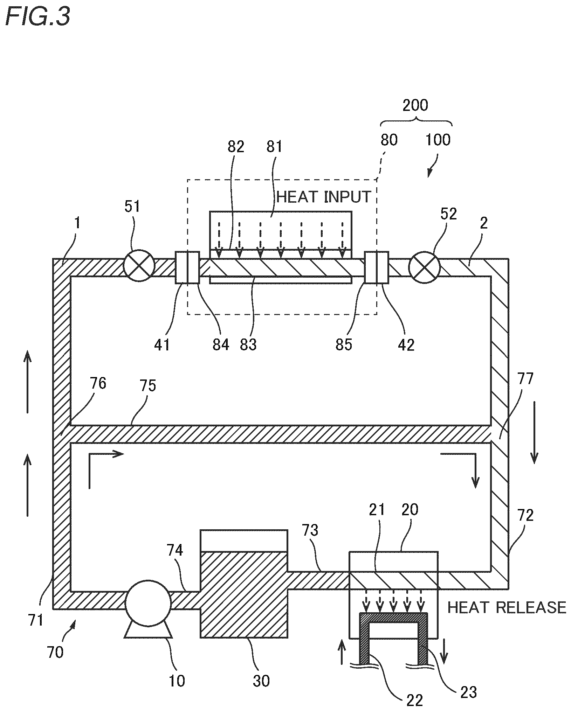

For example, while the example in which the flow regulator 60 is provided in the bypass line 75 has been shown in the aforementioned first embodiment, the present invention is not limited to this. For example, as in a first modified example shown in FIG. 3, the flow regulator 60 may not be provided in the bypass line 75. When the flow regulator 60 is not provided in the bypass line 75, the distributions of the flow rate of the refrigerant flowing into the evaporator 80 and the flow rate of the refrigerant flowing into the bypass line 75 in a state in which the evaporator 80 is connected can be adjusted by the pipe diameter and/or flow path length of the bypass line 75, for example.

While the example in which the flow rate of the refrigerant flowing into the evaporator 80 is greater than the flow rate of the refrigerant flowing into the bypass line 75 has been shown in the aforementioned first embodiment, the present invention is not limited to this. For example, the flow rate of the refrigerant flowing into the evaporator 80 may be equal to the flow rate of the refrigerant flowing into the bypass line 75, or the flow rate of the refrigerant flowing into the evaporator 80 may be less than the flow rate of the refrigerant flowing into the bypass line 75.

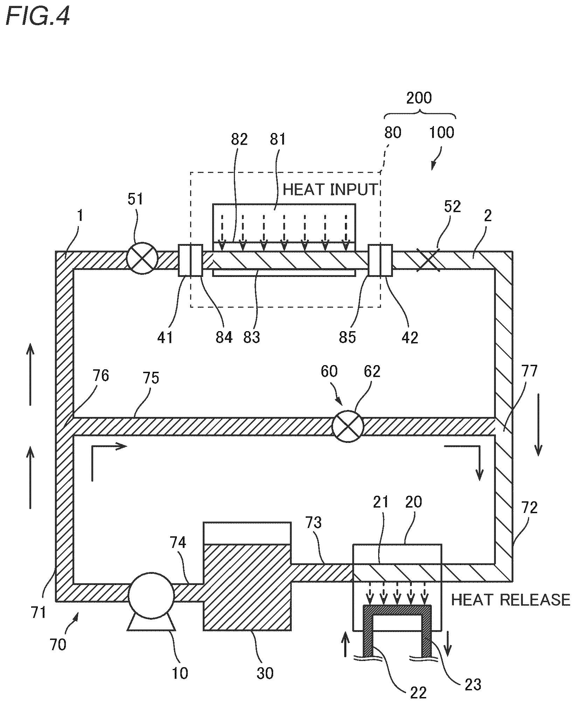

While the example in which the flow regulator 60 includes the orifice 61 has been shown in the aforementioned first embodiment, the present invention is not limited to this. For example, as in a second modified example shown in FIG. 4, the flow regulator 60 may include a flow rate adjustment valve 62. The flow rate adjustment valve 62 is not particularly limited as long as the same is a known valve such as a needle valve that can be shut off and adjust the flow rate. The opening degree adjustment of the flow rate adjustment valve 62 may be performed manually or by computer control.

When the flow regulator 60 includes the flow rate adjustment valve 62, the opening degree of the flow rate adjustment valve 62 may be adjusted according to the cooling level of the target to be cooled, which is the heat source 81. For example, the opening degree of the flow rate adjustment valve 62 in a state in which the need for cooling the target to be cooled is lower than in the normal operating state can be larger than the opening degree of the flow rate adjustment valve 62 in the normal operating state. Thus, the flow rate of the refrigerant flowing into the evaporator 80 can be less than the flow rate of the refrigerant flowing into the bypass line 75, for example. Furthermore, it is not necessary to adjust the flow rate of the refrigerant flowing into the evaporator 80 by the pump 10, and thus the burden on the pump 10 can be reduced. In addition, when it is desired to cause the flow rate of the refrigerant flowing into the evaporator 80 to be equal to or less than the minimum flow rate of the pump 10, the flow rate of the refrigerant flowing into the evaporator 80 can be adjusted to be smaller by adjusting the opening degree of the flow rate adjustment valve 62 to be larger.

While the example in which the inlet side shut-off valve 51 and the outlet side shut-off valve 52 are provided has been shown in the aforementioned first embodiment, the present invention is not limited to this. For example, both the inlet side shut-off valve 51 and the outlet side shut-off valve 52 may not be provided, or either the inlet side shut-off valve 51 or the outlet side shut-off valve 52 may not be provided.

While the example in which the bypass line 75 is connected to the portion downstream of the outlet connection 42 and upstream of the condenser 20 has been shown in the aforementioned first embodiment, the present invention is not limited to this. For example, the bypass line 75 may be directly connected to the condenser 20 and may not be connected to the flow path between the outlet connection 42 and the condenser 20.

While the example in which the reservoir 30 is provided has been shown in the first embodiment, the present invention is not limited to this. For example, the reservoir 30 may not be provided.

While the example in which the circulation device 100 for a two-phase cooling system is portable has been shown in the first embodiment, the present invention is not limited to this. For example, the circulation device 100 for a two-phase cooling system may be fixed in position.

While the example in which when the evaporator 80 is connected, the gas-liquid mixed refrigerant 2 flowing out of the evaporator 80 flows into the condenser 20 has been shown in the first embodiment, the present invention is not limited to this. For example, the refrigerant flowing out of the evaporator 80 may be in a single-phase gas state.

While the example in which the detector 31 is a liquid level sensor, and detects the amount of refrigerant stored in the reservoir 30 as the amount of recovered refrigerant by measuring the liquid level 3 of the liquid refrigerant 1 stored in the reservoir 30 has been shown in the second embodiment, the present invention is not limited to this. For example, the detector may be a differential pressure level sensor, and may detect the amount of refrigerant stored in the reservoir as the amount of recovered refrigerant by measuring the height of the liquid level based on a difference between a pressure at the bottom of the reservoir and a pressure at the liquid level. Alternatively, the detector may be another known sensor.

While the example in which the set liquid level 5 is set by the controller 91 has been shown in the second embodiment, the present invention is not limited to this. For example, the set liquid level 5 may be set by a user.

While the example in which the detector 31 detects the amount of refrigerant stored in the reservoir 30 as the amount of recovered refrigerant has been shown in the second embodiment, the present invention is not limited to this. For example, the circulation device for a two-phase cooling system may include detectors in the vicinity of the inlet of the reservoir and in the vicinity of the outlet of the reservoir to detect the amount of recovered refrigerant based on a refrigerant flow rate detected by the detector in the vicinity of the inlet and a refrigerant flow rate detected by the detector in the vicinity of the outlet. In such a case, when a difference between the refrigerant flow rate detected by the detector in the vicinity of the inlet and the refrigerant flow rate detected by the detector in the vicinity of the outlet becomes equal to or less than a threshold, the controller may perform a control to stop the operation of the pump to terminate the refrigerant recovery process. Alternatively, the circulation device for a two-phase cooling system may include a detector between the outlet side shut-off valve and the junction to detect the amount of recovered refrigerant based on a refrigerant flow rate detected by the detector, for example.

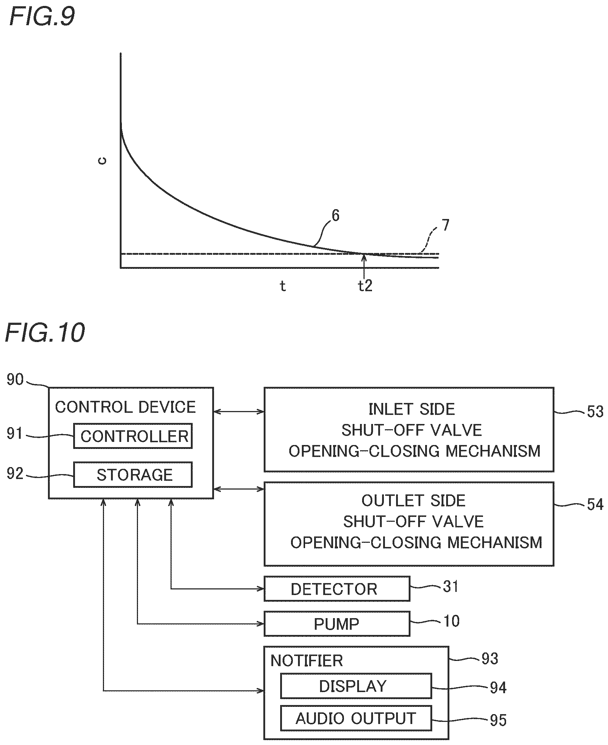

While the example in which the controller 91 performs a control to stop the operation of the pump 10 to terminate the refrigerant recovery process when the amount of stored refrigerant detected by the detector 31 becomes equal to or greater than the set storage amount, which is set in advance, has been shown in the second embodiment, the present invention is not limited to this. For example, as in a third modified example, the controller 91 may perform a control to stop the operation of the pump 10 to terminate the refrigerant recovery process when the amount of change in the amount of stored refrigerant detected by the detector 31 becomes equal to or less than a set change amount, which is set in advance. The amount of change in the amount of stored refrigerant includes the amount of change 6 in the liquid level of the refrigerant (see FIG. 9).

As shown in FIG. 9, immediately after the inlet side shut-off valve 51 is closed in the refrigerant recovery state, the amount of change 6 per unit time of the liquid level of the liquid refrigerant 1 stored in the reservoir 30 is the largest, and as time t passes, the amount of change 6 per unit time of the liquid level of the liquid refrigerant 1 becomes smaller. Therefore, the amount of change per unit time in the liquid level of the liquid refrigerant 1 is set in advance as a set change amount 7. The set change amount 7 is a reference value at which it can be considered that the refrigerant remaining in the evaporator 80 has been recovered into the reservoir 30. The set change amount 7 is set in advance by the user and is stored in the storage 92.

In the refrigerant recovery state, the controller 91 acquires the liquid level of the liquid refrigerant 1 stored in the reservoir 30, detected by the detector 31. The controller 91 acquires the amount of change 6 per unit time of the liquid level of the liquid refrigerant 1, based on the liquid level of the liquid refrigerant 1 detected by the detector 31. Then, when the amount of change 6 of the liquid level of the liquid refrigerant 1 becomes equal to or less than the set change amount 7, which is set in advance (time t2), the controller 91 performs a control to close the outlet side shut-off valve 52 to prevent the refrigerant from flowing out from the outlet side shut-off valve 52 toward the outlet connection 42, and also performs a control to stop the operation of the pump 10 to terminate the refrigerant recovery process.

According to the third modified example, as described above, when the amount of change in the amount of stored refrigerant detected by the detector 31 while the refrigerant is circulating through the bypass line 75 without passing through the evaporator 80 becomes equal to or less than the set change amount 7, which is set in advance, in the refrigerant recovery state, the controller 91 performs a control to stop the operation of the pump 10 to terminate the refrigerant recovery process. Thus, even when the total amount of refrigerant changes due to a decrease in the amount of refrigerant in the normal operating state in which the heat source 81 is cooled, for example, the controller 91 can reliably detect that the refrigerant remaining in the evaporator 80 has been recovered into the reservoir 30 based on the set change amount 7.

Furthermore, the controller 91 may perform a control to stop the operation of the pump 10 to terminate the refrigerant recovery process when the liquid level 3 of the liquid refrigerant 1 detected by the detector 31 becomes equal to or greater than the set liquid level **5,** which is set in advance (see FIG. 7), and the amount of change 6 of the liquid level of the liquid refrigerant 1 detected by the detector 31 becomes equal to or less than the set change amount **7,** which is set in advance.

While the example in which the controller 91 performs a control to close the inlet side shut-off valve 51 using the inlet side shut-off valve opening-closing mechanism 53, a control to close the outlet side shut-off valve 52 using the outlet side shut-off valve opening-closing mechanism 54 based on the set storage amount, and a control to stop the operation of the pump 10 based on the set storage amount has been shown in the second embodiment, the present invention is not limited to this. For example, the user may perform any or all of an operation to close the inlet side shut-off valve 51, an operation to close the outlet side shut-off valve 52 based on the set storage amount, and an operation to stop the operation of the pump 10 based on the set storage amount. When the user performs all of the operations to close the inlet side shut-off valve 51, to close the outlet side shut-off valve 52 based on the set storage amount, and to stop the operation of the pump 10 based on the set storage amount, the controller may not be provided.

For example, before the refrigerant is recovered from the evaporator 80, the user may manually close the inlet side shut-off valve 51. Furthermore, the user may manually close the outlet side shut-off valve 52 based on visual confirmation of a liquid level gauge. Moreover, the user may execute an operation to stop the operation of the pump 10 based on the visual confirmation of the liquid level gauge.

While the example in which the controller 91 performs a control to close the outlet side shut-off valve 52 using the outlet side shut-off valve opening-closing mechanism 54 and stop the operation of the pump 10 to terminate the refrigerant recovery process when the amount of stored refrigerant detected by the detector 31 becomes equal to or greater than the set storage amount, which is set in advance, or when the amount of change in the amount of stored refrigerant detected by the detector 31 becomes equal to or less than the set change amount has been shown in each of the second embodiment and the third modified example, the present invention is not limited to this. For example, as in a fourth modified example, the circulation device 300 for a two-phase cooling system may further include a notifier 93, and the controller 91 may notify the user using the notifier 93 that the amount of stored refrigerant detected by the detector 31 has become equal to or greater than the set storage amount, or that the amount of change in the amount of stored refrigerant detected by the detector 31 has become equal to or less than the set change amount. Accordingly, the user can recognize that the amount of stored refrigerant detected by the detector 31 has become equal to or greater than the set storage amount, or that the amount of change in the amount of stored refrigerant detected by the detector 31 has become equal to or less than the set change amount, and thus the user can be promptly caused to execute an operation to close the outlet side shut-off valve 52 and an operation to stop the operation of the pump 10.

When the user is notified of the above by the notifier 93, the user performs an operation to close the outlet side shut-off valve 52 and an operation to stop the operation of the pump 10.

In such a case, the notifier 93 may include a display 94, and the controller 91 may control the display 94 to display a notification that "the refrigerant has been recovered" when the amount of stored refrigerant detected by the detector 31 becomes equal to or greater than the set storage amount, which is set in advance, or when the amount of change in the amount of stored refrigerant detected by the detector 31 becomes equal to or less than the set change amount. Alternatively, the notifier 93 may include an audio output 95 instead of or in addition to the display 94, and the controller 91 may control the audio output 95 to announce that "the refrigerant has been recovered" when the amount of stored refrigerant detected by the detector 31 becomes equal to or greater than the set storage amount, which is set in advance, or when the amount of change in the amount of stored refrigerant detected by the detector 31 becomes equal to or less than the set change amount.

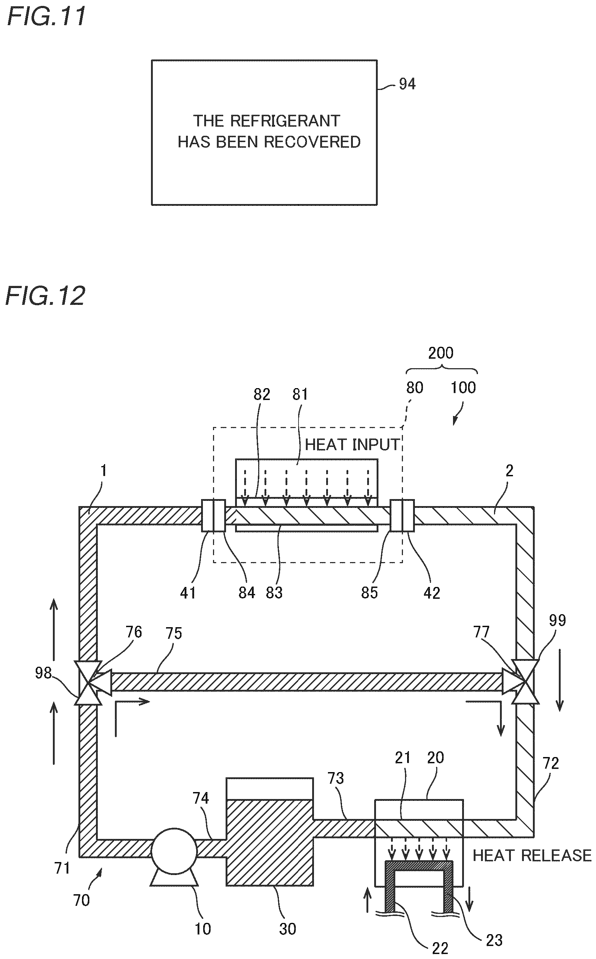

While the example in which the inlet side shut-off valve 51, the outlet side shut-off valve 52, and the flow regulator 60 are provided has been shown in each of the first embodiment and the second embodiment, the present invention is not limited to this. For example, as in a fifth modified example shown in FIG. 12, instead of the inlet side shut-off valve 51, the outlet side shut-off valve 52, and the flow regulator 60, a first three-way valve 98 may be provided at the bifurcation 76, and a second three-way valve 99 may be provided at the junction 77. In such a case, the controller 91 may control switching of the first three-way valve 98 and the second three-way valve **99,** or the user may perform switching of the first three-way valve 98 and the second three-way valve **99.**

### Aspects

It will be appreciated by those skilled in the art that the exemplary embodiments described above are specific examples of the following aspects.

### (Item 1)

A circulation device for a two-phase cooling system, the circulation device that constitutes the two-phase cooling system in which a refrigerant is circulated by connecting a removable evaporator to the circulation device, the circulation device comprising:
a pump to pump the refrigerant;
an inlet connection downstream of the pump connected to an inlet of the evaporator for the refrigerant, and an outlet connection downstream of the pump connected to an outlet of the evaporator for the refrigerant;
a condenser downstream of the outlet connection to cool the refrigerant; and
a bypass line branching at a portion downstream of the pump and upstream of the inlet connection to allow the refrigerant to flow to the condenser without passing through the inlet connection and the outlet connection; wherein
the circulation device is operable to circulate the refrigerant not through the inlet connection and the outlet connection but through the bypass line when at least the evaporator is not connected to the inlet connection and the outlet connection.

### (Item 2)

The circulation device for a two-phase cooling system according to item 1, wherein in a normal operating state in which the evaporator is connected to the inlet connection and the outlet connection, a portion of the refrigerant is circulated through the evaporator, and a remaining portion of the refrigerant is circulated through the bypass line.

### (Item 3)

The circulation device for a two-phase cooling system according to item 1 or 2, further comprising:
a flow regulator in the bypass line.

### (Item 4)

The circulation device for a two-phase cooling system according to item 3, wherein the flow regulator includes an orifice to adjust a flow rate of the refrigerant flowing through the bypass line.

### (Item 5)

The circulation device for a two-phase cooling system according to item 3, wherein the flow regulator includes a flow rate adjustment valve to adjust a flow rate of the refrigerant flowing through the bypass line.

### (Item 6)

The circulation device for a two-phase cooling system according to any one of items 1 to 5, wherein the condenser is operable to condense and cool a gas-phase refrigerant contained in a gas-liquid mixed refrigerant of the refrigerant with a coolant flowing in from an outside, or to cool a liquid refrigerant of the refrigerant.

### (Item 7)

The circulation device for a two-phase cooling system according to any one of items 1 to 6, wherein the bypass line branches at a portion downstream of the pump and upstream of the inlet connection, and is connected to a portion downstream of the outlet connection and upstream of the condenser.

### (Item 8)

The circulation device for a two-phase cooling system according to item 7, further comprising:
an inlet side shut-off valve between a bifurcation at which the bypass line branches on a downstream side of the pump and the inlet connection to open and close a flow path of the refrigerant, and an outlet side shut-off valve between the outlet connection and a connection portion to which the bypass line is connected on a downstream side of the outlet connection to open and close the flow path of the refrigerant.

### (Item 9)

The circulation device for a two-phase cooling system according to any one of items 1 to 8, further comprising:
a reservoir downstream of the condenser and upstream of the pump.

### (Item 10)

The circulation device for a two-phase cooling system according to any one of items 1 to 9, wherein when the evaporator is connected to the inlet connection and the outlet connection, a gas-liquid mixed refrigerant flowing out of the evaporator flows into the condenser.

### (Item 11)

The circulation device for a two-phase cooling system according to item 1, further comprising:
an inlet side shut-off valve between a bifurcation at which the bypass line branches on a downstream side of the pump and the inlet connection to open and close a flow path of the refrigerant; wherein
when the refrigerant is recovered from the evaporator, the refrigerant is circulated through the bypass line without passing through the evaporator, and the refrigerant in the evaporator is led to the condenser, in a refrigerant recovery state in which the evaporator is connected to the inlet connection and the outlet connection and the inlet side shut-off valve is closed.

### (Item 12)

The circulation device for a two-phase cooling system according to item 11, further comprising:
a detector to detect an amount of recovered refrigerant; and
a controller configured or programmed to stop operation of the pump to terminate a recovery process of the refrigerant based on a detection result of the detector.

### (Item 13)

The circulation device for a two-phase cooling system according to item 12, further comprising:
a reservoir downstream of the condenser and upstream of the pump; wherein
the detector is operable to detect an amount of stored refrigerant in the reservoir as the amount of recovered refrigerant.

### (Item 14)

The circulation device for a two-phase cooling system according to item 13, wherein the controller is configured or programmed to, in the refrigerant recovery state, perform a control to stop the operation of the pump to terminate the recovery process of the refrigerant when the amount of stored refrigerant detected by the detector while the refrigerant is circulating through the bypass line without passing through the evaporator becomes equal to or greater than a set storage amount, which is set in advance.

### (Item 15)

The circulation device for a two-phase cooling system according to item 13, wherein the controller is configured or programmed to, in the refrigerant recovery state, perform a control to stop the operation of the pump to terminate the recovery process of the refrigerant when an amount of change in the amount of stored refrigerant detected by the detector while the refrigerant is circulating through the bypass line without passing through the evaporator becomes equal to or less than a set change amount, which is set in advance.

### (Item 16)

The circulation device for a two-phase cooling system according to item 14 or 15, further comprising:
a notifier to notify a user that the amount of stored refrigerant detected by the detector has become equal to or greater than the set storage amount, or that an amount of change in the amount of stored refrigerant detected by the detector has become equal to or less than the set change amount.

### (Item 17)

The circulation device for a two-phase cooling system according to item 13, further comprising:
an outlet side shut-off valve between the outlet connection and a connection portion to which the bypass line is connected on a downstream side of the outlet connection to open and close the flow path of the refrigerant; wherein
the controller is configured or programmed to, based on the detection result of the detector, perform a control to close the outlet side shut-off valve to prevent the refrigerant from flowing out from the outlet side shut-off valve toward the outlet connection.

### (Item 18)

A refrigerant circulation method in a circulation device for a two-phase cooling system, the circulation device that constitutes the two-phase cooling system in which a refrigerant is circulated by connecting a removable evaporator to the circulation device, the refrigerant circulation method comprising:
circulating the refrigerant not through an inlet connection connected to an inlet of the evaporator for the refrigerant, and an outlet connection connected to an outlet of the evaporator for the refrigerant but through a bypass line operable to allow the refrigerant to flow therethrough when at least the evaporator is not connected to the inlet connection and the outlet connection; and
cooling the refrigerant that has flowed through the bypass line into a condenser.

### (Item 19)

The refrigerant circulation method according to item 18, further comprising:
circulating the refrigerant not through the evaporator but through the bypass line and leading the refrigerant in the evaporator to the condenser, in a refrigerant recovery state in which the evaporator is connected to the inlet connection and the outlet connection and an inlet side shut-off valve between a bifurcation at which the bypass line branches and the inlet connection is closed, when the refrigerant is recovered from the evaporator; and
stopping circulation of the refrigerant to terminate a recovery process of the refrigerant based on a detection result of an amount of recovered refrigerant.

### Description of Reference Numerals

2: gas-liquid mixed refrigerant
5: set liquid level (set storage amount)
7: set change amount
10: pump
20: condenser
23: coolant
30: reservoir
31: detector
41: inlet connection
42: outlet connection
51: inlet side shut-off valve
52: outlet side shut-off valve
60: flow regulator
61: orifice
62: flow rate adjustment valve
75: bypass line
80: evaporator
91: controller
93: notifier
100, 300: circulation device for a two-phase cooling system
200, 400: two-phase cooling system

## Claims

1. A circulation device for a two-phase cooling system, the circulation device that constitutes the two-phase cooling system in which a refrigerant is circulated by connecting a removable evaporator to the circulation device, the circulation device comprising:
a pump to pump the refrigerant;
an inlet connection downstream of the pump connected to an inlet of the evaporator for the refrigerant, and an outlet connection downstream of the pump connected to an outlet of the evaporator for the refrigerant;
a condenser downstream of the outlet connection to cool the refrigerant; and
a bypass line branching at a portion downstream of the pump and upstream of the inlet connection to allow the refrigerant to flow to the condenser without passing through the inlet connection and the outlet connection; wherein
the circulation device is operable to circulate the refrigerant not through the inlet connection and the outlet connection but through the bypass line when at least the evaporator is not connected to the inlet connection and the outlet connection.

2. The circulation device for a two-phase cooling system according to claim 1, wherein in a normal operating state in which the evaporator is connected to the inlet connection and the outlet connection, a portion of the refrigerant is circulated through the evaporator, and a remaining portion of the refrigerant is circulated through the bypass line.

3. The circulation device for a two-phase cooling system according to claim 1 or 2, further comprising:
a flow regulator in the bypass line.

4. The circulation device for a two-phase cooling system according to claim 3, wherein the flow regulator includes an orifice to adjust a flow rate of the refrigerant flowing through the bypass line.

5. The circulation device for a two-phase cooling system according to claim 3, wherein the flow regulator includes a flow rate adjustment valve to adjust a flow rate of the refrigerant flowing through the bypass line.

6. The circulation device for a two-phase cooling system according to claim 1, wherein the condenser is operable to condense and cool a gas-phase refrigerant contained in a gas-liquid mixed refrigerant of the refrigerant with a coolant flowing in from an outside, or to cool a liquid refrigerant of the refrigerant.

7. The circulation device for a two-phase cooling system according to claim 1, wherein the bypass line branches at a portion downstream of the pump and upstream of the inlet connection, and is connected to a portion downstream of the outlet connection and upstream of the condenser.

8. The circulation device for a two-phase cooling system according to claim 7, further comprising:
an inlet side shut-off valve between a bifurcation at which the bypass line branches on a downstream side of the pump and the inlet connection to open and close a flow path of the refrigerant, and an outlet side shut-off valve between the outlet connection and a connection portion to which the bypass line is connected on a downstream side of the outlet connection to open and close the flow path of the refrigerant.

9. The circulation device for a two-phase cooling system according to claim 1, further comprising:
a reservoir downstream of the condenser and upstream of the pump.

10. The circulation device for a two-phase cooling system according to claim 1, wherein when the evaporator is connected to the inlet connection and the outlet connection, a gas-liquid mixed refrigerant flowing out of the evaporator flows into the condenser.

11. The circulation device for a two-phase cooling system according to claim 1, further comprising:
an inlet side shut-off valve between a bifurcation at which the bypass line branches on a downstream side of the pump and the inlet connection to open and close a flow path of the refrigerant; wherein
when the refrigerant is recovered from the evaporator, the refrigerant is circulated through the bypass line without passing through the evaporator, and the refrigerant in the evaporator is led to the condenser, in a refrigerant recovery state in which the evaporator is connected to the inlet connection and the outlet connection and the inlet side shut-off valve is closed.

12. The circulation device for a two-phase cooling system according to claim 11, further comprising:
a detector to detect an amount of recovered refrigerant; and
a controller configured or programmed to stop operation of the pump to terminate a recovery process of the refrigerant based on a detection result of the detector.

13. The circulation device for a two-phase cooling system according to claim 12, further comprising:
a reservoir downstream of the condenser and upstream of the pump; wherein
the detector is operable to detect an amount of stored refrigerant in the reservoir as the amount of recovered refrigerant.

14. The circulation device for a two-phase cooling system according to claim 13, wherein the controller is configured or programmed to, in the refrigerant recovery state, perform a control to stop the operation of the pump to terminate the recovery process of the refrigerant when the amount of stored refrigerant detected by the detector while the refrigerant is circulating through the bypass line without passing through the evaporator becomes equal to or greater than a set storage amount, which is set in advance.

15. The circulation device for a two-phase cooling system according to claim 13, wherein the controller is configured or programmed to, in the refrigerant recovery state, perform a control to stop the operation of the pump to terminate the recovery process of the refrigerant when an amount of change in the amount of stored refrigerant detected by the detector while the refrigerant is circulating through the bypass line without passing through the evaporator becomes equal to or less than a set change amount, which is set in advance.

16. The circulation device for a two-phase cooling system according to claim 14 or 15, further comprising:
a notifier to notify a user that the amount of stored refrigerant detected by the detector has become equal to or greater than the set storage amount, or that an amount of change in the amount of stored refrigerant detected by the detector has become equal to or less than the set change amount.

17. The circulation device for a two-phase cooling system according to claim 13, further comprising:
an outlet side shut-off valve between the outlet connection and a connection portion to which the bypass line is connected on a downstream side of the outlet connection to open and close the flow path of the refrigerant; wherein
the controller is configured or programmed to, based on the detection result of the detector, perform a control to close the outlet side shut-off valve to prevent the refrigerant from flowing out from the outlet side shut-off valve toward the outlet connection.

18. A refrigerant circulation method in a circulation device for a two-phase cooling system, the circulation device that constitutes the two-phase cooling system in which a refrigerant is circulated by connecting a removable evaporator to the circulation device, the refrigerant circulation method comprising:
circulating the refrigerant not through an inlet connection connected to an inlet of the evaporator for the refrigerant, and an outlet connection connected to an outlet of the evaporator for the refrigerant but through a bypass line operable to allow the refrigerant to flow therethrough when at least the evaporator is not connected to the inlet connection and the outlet connection; and
cooling the refrigerant that has flowed through the bypass line into a condenser.

19. The refrigerant circulation method according to claim 18, further comprising:
circulating the refrigerant not through the evaporator but through the bypass line and leading the refrigerant in the evaporator to the condenser, in a refrigerant recovery state in which the evaporator is connected to the inlet connection and the outlet connection and an inlet side shut-off valve between a bifurcation at which the bypass line branches and the inlet connection is closed, when the refrigerant is recovered from the evaporator; and
stopping circulation of the refrigerant to terminate a recovery process of the refrigerant based on a detection result of an amount of recovered refrigerant.
